Europäisches Patentamt

European Patent Office

Office européen des brevets

(11) Veröffentlichungsnummer: **0 341 451**

**A1**

(12) **EUROPÄISCHE PATENTANMELDUNG**

(21) Anmeldenummer: 89106878.5

(22) Anmeldetag: 17.04.89

(51) Int. Cl.4: **H01L 21/20 , B01D 46/52 , C23C 16/00**

(30) Priorität: 09.05.88 DE 3815838

(43) Veröffentlichungstag der Anmeldung:
15.11.89 Patentblatt 89/46

(84) Benannte Vertragsstaaten:
AT BE CH DE FR GB IT LI LU NL SE

(71) Anmelder: **Siemens Aktiengesellschaft**
**Wittelsbacherplatz 2**
**D-8000 München 2(DE)**

(72) Erfinder: **Treichel, Helmuth, Dipl.-Ing. (FH)**
**Weldishoferstrasse 4**
**D-8900 Augsburg(DE)**
Erfinder: **Fuchs, Dieter, Dipl.-Ing. (FH)**
**Bunzlauerplatz 1**
**D-8000 München 50(DE)**
Erfinder: **Stolz, Manfred, Dipl.-Ing. (FH)**
**Lannerstrasse 10**
**D-8025 Unterhaching(DE)**

(54) **Filteranordnung für den Abgasstrom bei Gasphasenabscheidungen in der Halbleitertechnik.**

(57) Zum Zurückhalten fester Bestandteile des Abgasstromes bei Gasphasenabscheidungen wird eine Filteranordnung vorgeschlagen, die ein in einem Filtergehäuse (1) angeordnetes Gewebefilter (4) aufweist. Das Filtergehäuse (1) weist einen Einlaß (2) und einen Auslaß (3) auf, durch den der Abgasstrom mittels einer Pumpe gesaugt wird und einen Filtergehäusedeckel (5) zum Öffnen des Filtergehäuses (1). Das Gewebefilter (4) ist nach dem Prinzip eines Faltenbalgs ausgebildet. Die Filteranordnung ist bei der Herstellung integrierter Schaltungen mit CVD-Verfahren einsetzbar.

EP 0 341 451 A1

## Filteranordnung für den Abgasstrom bei Gasphasenabscheidungen in der Halbleitertechnik

Die Erfindung betrifft eine Filteranordnung zum Zurückhalten fester Bestandteile des mittels einer Pumpe abgeleiteten Abgasstromes bei Gasphasenabscheidungen in der Halbleitertechnik.

Zur Herstellung integrierter Schaltungen werden Bearbeitungsprozesse eingesetzt, bei denen Stoffe aus der Gasphase abgeschieden werden. Bei der chemischen Dampfabscheidung bei Unterdruck (LPCVD = Low Pressure Chemical Vapour Deposition) werden z. B. die Substanzen Tetraethylorthosilikat, Arsen (III)-Säuretriethylester, Arsen (V)-Säuretriethyelster, Trimethylborat, Trimethylphosphat und Tantalpentachlorid eingesetzt. Im Abgasstrom finden sich dann feste Reaktionsprodukte wie z. B. Arsenosilikatglas, Borosilikatglas, Phosphosilikatglas, Borophosphosilikatglas, Siliziumdioxid und Tantal- sowie Tantalnitridverbindungen, die zur Vermeidung von Kontaminationen der Abluft und zum Schutz der LPCVD-Anlagen und Pumpen durch Abscheideverfahren zurückgehalten werden müssen.

Abscheider, die nach dem allgemein bekannten Verfahren der Kühlfalle, z. B. mit flüssigem Stickstoff, arbeiten, kamen bislang bevorzugt zur Anwendung und sind im US-Patent 3,934,060 und im Journal of the Electrochemical Society: Solid State Science, Vol. 115, No. 6, Seite 649-652, erwähnt.

Der Einsatz von Kühlfallen zur Abscheidung fester Bestandteile des Abgasstromes bei der Gasphasenabscheidung hat viele Nachteile. Zur effektiven Abgasreinigung müssen Anlagen mit voluminöser Ausführung eingesetzt werden. Die Wartungs- und Reinigungsarbeiten beim Austausch der Kühlfallen sind erheblich, die Versorgung mit z.B. flüssigem Stickstoff ist kostenintensiv und aufgrund der benötigten Umpumpanlagen und der Versorgung aus Kryobehältern aufwendig. Bei den Temperaturen des flüssigen Stickstoffs werden auch leicht flüchtige Reaktionsprodukte ausgefroren, die beim Wechsel der Kühlfalle entweichen und durch Rückdiffusion zur Gasphasenabscheidungsanlage Brände oder Explosionen verursachen können. Eventuell austretende Kühlflüssigkeit und eingekühlte Abscheider können den Prozeß der Gasphasenabscheidung in der Anlage beeinträchtigen und die Anlage, speziell die Elektronik, belasten. Es treten lokale Abkühlungen und kondensierende Luftfeuchtigkeit auf.

Kondensatabscheider, bei denen die Abscheidung fester Bestandteile durch Kondensation bewirkt wird, weisen aus wartungs- und sicherheitstechnischen Gründen die gleichen Probleme wie Kühlfallen auf. Durch die beim Betrieb von Kondensatabscheidern auftretenden hohen Strömungswiderstände (Vielfachumlenkung des Abgasstromes) wird die Saugleistung der Pumpen stark beeinträchtigt. Im Firmenprospekt der Firma Pfeifer/Balzers-Gruppe Nr. PK 800079, B,D,E,F (5.Ausgabe) sind einige solche Kondensatabscheider beschrieben.

Aufgabe der Erfindung ist es, eine Anordnung zum Zurückhalten fester Bestandteile des Abgasstromes bei Gasphasenabscheidungen anzugeben, die die genannten Nachteile vermeidet. Die Anordnung soll insbesondere so gestaltet sein, daß die notwendigen Wartungs-und Reinigungsarbeiten und die damit verbundene Ausfallzeit der Gasphasenabscheidungsanlagen minimiert wird. Der Ein- und Ausbau, sowie die Entsorgung und Reinigung des Abscheidesystems soll sicherheitstechnisch problemlos sein.

Zur Lösung dieser Aufgabe wird eine Filteranordnung der eingangs genannten Art vorgeschlagen, die gekennzeichnet ist durch

a) ein Filtergehäuse mit einem Einlaß und einem Auslaß für den Abgasstrom und einem Filtergehäusedeckel zum Öffnen des Filtergehäuses und

b) ein nach dem Prinzip eines Faltenbalgs ausgebildetes zellulosehaltiges Gewebefilter, das so im Filtergehäuse angeordnet ist, daß der durch den Einlaß in das Filtergehäuse geleitete Abgasstrom durch das Gewebefilter hindurch zum Auslaß des Filtergehäuses strömt.

Weitere Ausgestaltungen und Weiterbildungen der Erfindung gehen aus den Unteransprüchen sowie der nachfolgend anhand eines Ausführungsbeispieles gegebenen Beschreibung hervor.

Die FIG zeigt in schematischer Darstellung eine erfindungsgemäße Filteranordnung für den Abgasstrom bei Gasphasenabscheidungen. Das Filtergehäuse 1 kann aus Edelstahl bestehen und weist einen Einlaß 2 und einen Auslaß 3 für den Abgaßstrom auf, wobei der Abgasstrom mittels einer auf der Seite Auslasses 3 angeschlossene Pumpe (nicht in der FIG dargestellt) abgepumpt wird. Das Filtergehäuse 1 enthält im Innern ein Gewebefilter 4, das zur Vergrößerung der Filteroberfläche nach dem Prinzip eines Faltenbalgs ausgebildet ist.

Als Gewebefilter wird ein filternder Abscheider verstanden, bei dem das zu reinigende feste Teilchen-Gas-Gemisch durch eine Schicht genügender Durchlässigkeit gesaugt oder gedrückt wird, wobei als filterndes Material Gewebe bzw. Vliessstoffe eingesetzt werden.

Das Gewebefilter 4 besteht aus einem zellulosehaltigem Material, das auch mit einem Harz imprägniert sein kann. Das Filtergehäuse 1 weist weiter einen Filtergehäusedeckel 5 auf, der durch Knebelschrauben 6 am Filtergehäuse 1 befestigt und durch einen Dichtungsring 7 gasdicht abgedichtet ist.

Das Gewebefilter 4 ist durch Haltestifte 8, 9 auf der Seite des Gehäusedeckels 5 und der Seite des Auslasses 3 im Filtergehäuse 1 befestigt und dabei durch Dichtungsringe 10, 11 auf der Seite des Gehäusedeckels 5 und der Seite des Auslasses 3 abgedichtet. Die Dichtungsringe 7, 10, 11 können aus Silikon oder Teflon hergestellt sein.

Durch Öffnen der Knebelschrauben 6 und Abnehmen des Filterge häusedeckels 5 ist das Gewebefilter 4 leicht und schnell austauschbar und das Filtergehäuse 1 zu reinigen. Als sicherheitstechnische Vorkehrungen sind dabei lediglich die Schutzkleidung des Bedienungspersonals, die fachgerechte Entsorgung des Gewebefilters und das Schließen der Ventile der angeschlossenen Pumpen zu beachten. Die benötigte Zeit für den Wechsel des Gewebefilters beträgt ca. 5 Minuten.

Die erfindungsgemäße Filteranordnung weist folgende Vorteile auf:

1. Es können handelsübliche Gewebefilter, z. B. Papierfaltenfilter verwendet werden, die mit Korngrößen erhältlich sind, bei denen Partikel mit einem Durchmesser ab ein Micrometer zurückgehalten werden.

2. Durch den geringen Strömungswiderstand der Anordnung wird die Saugleistung der angeschlossenen Pumpen praktisch nicht mehr reduziert.

3. Der Wechsel der Gewebefilter ist einfach und in kurzer Zeit durchführbar, so daß die Standzeit der Gasphasenabscheidungsanlage auf ein Minimum reduziert ist.

4. Eine naßchemische Reinigung der Filteranordnung muß wesentlich seltener erfolgen als bei den bisher bekannten Filtersystemen, so daß die Gefahr für das Wartungspersonal stark reduziert ist.

5. Durch den einfachen Aufbau der Filteranordnung sind die Anschaffungs- und Betriebskosten stark reduziert.

6. Eine Belastung der Gasphasenabscheidungsanlage (insbesondere der Elektronik) und des Reinraumes durch austretende Kühlflüssigkeit und deren Dämpfe entfällt.

7. Die Gefahr eines Rohrbrandes oder einer Explosion durch Rückdiffusion von auftauenden flüchtigen Reaktionskomponenten entfällt.

8. Insgesamt ergibt sich eine höhere Betriebszeit der Gasphasenabscheidungsanlage und des Zubehörs wie Vakuumpumpen und Quarzgut.

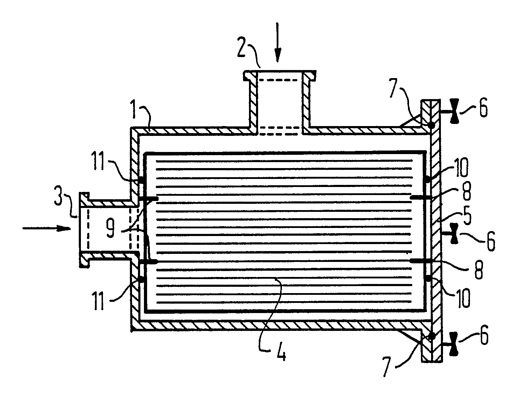

## Ansprüche

1. Filteranordnung zum Zurückhalten fester Bestandteile des mittels einer Pumpe abgeleiteten Abgasstromes bei Gasphasenabscheidungen in der Halbleitertechnik,
**gekennzeichnet durch**
   a) ein Filtergehäuse (1) mit einem Einlaß (2) und einem Auslaß (3) für den Abgasstrom und einem Filtergehäusedeckel (5) zum Öffnen des Filtergehäuses (1) und
   b) ein nach dem Prinzip eines Falkenbalks ausgebildetes zellulosehaltiges Gewebefilter (4), das so im Filtergehäuse (1) angeordnet ist, daß der durch den Einlaß (2) in das Filtergehäuse (I) geleitete Abgasstrom durch das Gewebefilter (4) hindurch zum Auslaß (3) des Filtergehäuses (1) strömt.

2. Filteranordnung nach Anspruch 1,
**gekennzeichnet durch** ein Gewebefilter (4), das aus einem mit Harz imprägnierten Zellulosematerial besteht.

3. Filteranordnung nach einem der Ansprüche 1 oder 3,
**dadurch gekennzeichnet,** daß das Filtergehäuse (1) aus Edelstahl besteht.

4. Filteranordnung nach einem der Ansprüche 1 bis 3,
**dadurch gekennzeichnet,** daß das Gewebefilter (4) im Auslaßbereich und im Bereich Filtergehäusedeckels abgedichtet ist.

5. Filteranordnung nach Anspruch 4,
**dadurch gekennzeichnet,** daß die Abdichtungen aus Dichtungsringen bestehen.

Europäisches
Patentamt

**EUROPÄISCHER RECHERCHENBERICHT**

Nummer der Anmeldung

EP 89106878.5

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| D,A | US - A - 3 934 060 (BURT) * Fig. 1; Zusammenfassung * | 1 | H 0 1 L 21/20 B 01 D 46/52 C 23 C 16/00 |
| Y | EP - A2 - 0 145 642 (HERTZ) * Zusammenfassung; Fig. 1; Anspruch 1 * | 1 | |
| Y | DE - A1 - 3 534 318 | 1 | |
| A | * Gesamt * | 4 | |
| A | CH - A5 - 653 913 (DRÄGERWERK) * Gesamt; insbesondere Seite 2, linke Spalte, Zeile 57 * | 1 | |

| | RECHERCHIERTE SACHGEBIETE (Int. Cl.4) |
|---|---|
| | H 01 L B 01 D C 23 C |

Der vorliegende Recherchenbericht wurde für alle Patentansprüche erstellt.

| Recherchenort WIEN | Abschlußdatum der Recherche 09-06-1989 | Prüfer HEINICH |
|---|---|---|